# EUROPEAN PATENT SPECIFICATION

(11) **EP 1 820 884 B1**
(45) Date of publication and mention of the grant of the patent: **07.10.2009**
(21) Application number: 06003278.6
(22) Date of filing: 17.02.2006
(51) Int. Cl.: C23F 1/18, C23F 1/44, H05K 3/38

(54) **Solution and process to treat surfaces of copper alloys in order to improve the adhesion between the metal surface and the bonded polymeric material**
Zusammensetzung und Verfahren zur Behandlung der Oberflächen von Kupferlegierungen, um die Haftfähigkeit zwischen der Metalloberfläche und dem gebundenen polymerischen Material zu verbessern
La solution et le processus pour traiter des surfaces des alliages de cuivre afin d'améliorer l'adhérence entre la surface métallique et le materiau polymèrique lié à celle-ci

(43) Date of publication of application: 22.08.2007
(73) Proprietor: ATOTECH Deutschland GmbH, 10553 Berlin (DE)
(72) Inventor: Wunderlich, Christian, 16727 Velten (DE); Barthelmes, Jürgen, 10407 Berlin (DE); Watanabe, Kiyoshi, Kanagawa 221-0855 (JP); Neoh, Din-Ghee, Singapore 680661 (SG); Lam, Patrick, Fanling, New Terretories Hong Kong (HK)
(74) Representative: Albrecht, Thomas

(56) References cited:
- EP-A- 1 031 644
- EP-A- 1 331 287
- US-A- 3 770 530
- US-A- 6 162 366
- US-A1- 2003 006 215
- US-A1- 2004 262 569
- US-A1- 2005 067 378
- US-B1- 6 666 987

## Description

The invention concerns a solution and a process to treat copper alloy surfaces so that a tight bond can be subsequently formed between the treated copper surfaces and polymeric material. The solution preferably serves to treat surfaces of lead frames made of copper alloys containing alloying elements selected from the group of Si, Ni, Fe, Zr, P, Sn.

In manufacturing lead frames and printed circuit boards alike, various steps are carried out in which copper surfaces must be tightly bonded to an organic substrate. In some cases, the required adhesion of the formed bonds must be ensured over a long period. In other cases, a tight bond only has to exist for a short period, e.g. when a polymeric material only remains on the copper or copper alloy surfaces during manufacture of the workpiece.

The easiest way to increase the adhesion is to etch and hence roughen the copper surfaces before forming the bond. Microetching solutions have long been used in the production of printed circuit boards and contain for example sulfuric acid solutions of hydrogen peroxide or sodium peroxodisulfate.

Another procedure is described in U.S. Pat. No. 3,645,772. A treatment solution is used for the copper surfaces that e.g. contains 5-aminotetrazole.

Long-term stability is especially necessary when encapsulating molding compounds (polymeric material) into lead frames.

Various procedures for pretreating printed circuit boards have been developed. Commonly, before lamination an oxide layer on the copper surfaces is formed. In this process, known as the brown or black oxide process, very aggressive reaction conditions are used to form the oxide. A disadvantage of this procedure is that the oxide layer used for enhancing adhesion to the polymeric material is not very resistant to acid and especially to hydrochloric treatment solutions. They are hence attacked in subsequent processes for plating the through-holes in the boards. The adhesive bond is eliminated, and delamination occurs at the attacked sites (pink ring: An externally-visible attack on the black oxide layer directly next to a hole in printed circuit boards with the discoloration of the originally black oxide layer.

The above-cited problem is solved by reducing the oxide layer surface before lamination. The reduced black oxide is more stable than normal black oxide against chemicals used in plating the through-holes. The additional reduction step costs a great deal, however. In addition, the chemicals used for reduction are not very resistant to oxidation from air, so that the useful life of the baths and storage life of the supplementary chemicals are limited. An attempt to eliminate this problem is made in JP A 08097559. The reduced copper oxide layers are provided with a protective layer by treating them with an aqueous solution containing an aminothiazole and/or aminobenzothiazole compound. However, the problems of expensive reduction chemicals, their low resistance to oxidation and the layer's sensitivity to acid are not completely eliminated.

Another option for promoting adhesion is to treat the copper surfaces with an aqueous or alcoholic solution of an azole compound. Such a procedure is e.g. presented in WO 96/19097 A1. The copper surfaces are treated with a solution that contains 0.1-20 weight percent hydrogen peroxide, an inorganic acid (e.g. sulfuric acid), an organic corrosion inhibitor (e.g. benzotrizole), and a wetting agent. The hydrogen peroxide etches the copper surface to produce microrough surfaces.

US 5,869,130 describes a process for treating metal surfaces with a composition comprising an oxidizer, an acid, a corrosion inhibitor, a source of halide ions and optionally a water soluble polymer in order to increase the adhesion of polymeric materials to the metal surface.

US 6,562,149 B1 discloses processes and solutions for the preliminary treatment of copper surfaces which are subsequently to be firmly bonded to organic substrates. The solution is used, in particular, for firmly bonding laminated multilayered printed circuit boards and for firmly bonding resists to the copper surfaces of printed circuit boards. The solutions contain (a) hydrogen peroxide; (b) at least one acid; (c) at least one nitrogen-containing, five-membered heterocyclic compound which does not contain any sulphur, selenium or tellurium atom in the heterocycle; and (d) at least one adhesive compound from the group consisting of sulfinic acids, seleninic acids, tellurinic acids, heterocyclic compounds containing at least one sulphur, selenium and/or tellurium atom in the heterocycle, and sulfonium, selenonium and telluronium salts.

However, as compared to the printed circuit board production the common metallic substrates used for lead frames are copper alloys with a certain, relatively low amount of alloying elements, required to achieve the mechanical and electrical properties sought.

Some alloys, however, are only partially attacked or with a reduced reaction rate. This leads to unsatisfactory roughness or insoluble residues or smut on the alloy surface. The result in both cases in a non optimized adhesion improvement achieved by the process.

United States patent 6,162,366 relates to an etching process, comprising: preparing an etchant containing ferric chloride and an anticorrosive agent for Cu, and etching with said etchant a multi-layer metal structure including a Cu layer and an Ni layer.

US 2005/0067378 A1 relates to a process to improve adhesion of dielectric materials to a metal layer, comprising: providing an unpatterned metal layer having a first major surface; micro-roughening the first major surface to form a micro-roughened surface; and etching the metal layer to form a circuit pattern in the metal layer, wherein the micro-roughening is carried out prior to the etching. According to one embodiment of this process, the micro-roughening is carried out by applying an aqueous composition comprising (a) a cupric ion source, (b) an organic acid with an acid dissociation constant (pKa) of 5 or lower, (c) a halide ion source, and (d) water.

EP 1 331 287 A2 relates to a method of treating a surface of a metal substrate comprising: a) changing an amount of at least one component of an oxide replacement composition by a sufficient amount to form a modified oxide replacement composition such that the modified oxide replacement composition does not form a reddish brown to black oxide film on the metal surface when contacting the metal surface; and b) contacting the metal surface with the modified oxide replacement composition to microroughen the metal surface. This composition comprises, for example, sulfuric acid, hydrogen peroxide (50%), benzotriazole, Carbowax^{®} MPEG 2000, sodium chloride and water.

EP 1 031 644 A1 relates to thiazole- and thiocarbamide-based chemicals for use with oxidative etchant solutions. In addition to the thiazole- and thiocarbamide-based compounds, the etchant solutions comprise a proton source, an oxidizer agent, a source of halogen ions and an azole compound.

The present invention is therefore based on the problem of avoiding the disadvantages of the state of the art and finding a treatment solution and a process that can create a tight bond between the copper alloy surfaces and polymeric material surfaces and is at the same time suitable to treat a wide range of different copper alloy compositions. The process should be simple, easy to use, and inexpensive. It is also important that treatment with the solutions produce a material bond that is not problematic (no smut formation, decomposition of the pre-treatment solution etc.). The used treatment solutions should therefore be particularly suitable for manufacturing lead frames.

This problem is solved by the solution cited in claim 1 and the treatment process cited in claim 19.

The solution according to the invention is for treating copper alloy surfaces to allow a tight bond to be formed with plastic materials, and it comprises:
a) an oxidant
b) at least one acid
c) at least one adhesion-enhancing compound
d) fluoride ions in an amount of 0.2-25 g/l
e) chloride ions in an amount of 5 to 40 mg per litre.

Adhesion-enhancing compounds are to be selected that are sufficiently soluble in the sulfuric acid solution.

The process according to the invention is carried out by bringing the copper alloy surfaces into contact with the solution.

The solution is also suitable for treatment of copper alloy surfaces, thereafter depositing a second metal layer on the such treated copper alloy surface and finally bond a polymeric material thereto. The second metal layer can for example be a deposit of Ni-Pd-Au or Ag, forming a solderable layer.
By roughening the copper alloy surface with a treatment solution according to claim 1, the adhesion properties of the polymeric material to the second metal layer are also greatly enhanced, which can be seen from the Example 4.

Preferred embodiments of the invention are the subject-matter of dependent claims 2-18.

Adhesion-enhancing compounds are selected from the group consisting of triazoles, benzotriazoles, imidazoles, tetrazoles, purines and mixtures thereof may be used. These compounds react with the copper alloy surfaces to form a protective complex layer.
Preferred tetrazole compounds are 5-aminotetrazole and 5-phenyltetrazole. A preferred imidazole compound may be benzimidazole. 5-aminotetrazole, 5-phenyltetrazole, benzotriazole, methylbenzotriazole and ethylbenzotriazole are preferred compounds given their favorable solubility in the treatment solution and their availability.
Preferred combinations are benzotriazole, methylbenzotriazole, ethylbenzotriazole, 5-aminotetrazole and 5-phenyltetrazole as the nitrogen-containing, heterocyclic compounds with aminothiophene carboxylic acids, their esters and amides, aminothiazoles and substituted aminothiazoles as the heterocyclic compounds.

In order to improve the long-term stability of the bond between the metal surface and the polymeric material, a mixture of at least one nitrogen-containing, five-membered heterocyclic compound that does not contain sulfur, selenium or tellurium atoms in the heterocycle and at least one adhesion-promoting compound selected from the group consisting of sulfinic acids, selenic acids, telluric acids, heterocyclic compounds that contain at least one sulfur, selenium and/or tellurium atom in the heterocycle, is applied.

Preferred sulfinic acids are compounds of chemical formula B: 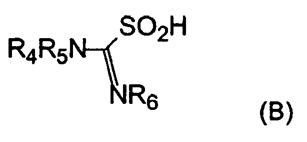 wherein R₄, R₅ and R₆ are selected from the group consisting of hydrogen, alkyl, substituted alkyl, phenyl, substituted phenyl and R₇ -(CO)- wherein R₇ is hydrogen, alkyl, substituted alkyl, phenyl or substituted phenyl, where R₄, R₅ and R₆ can be the same or different.

It is preferable for the solution to contain formamidine sulfinic acid. Preferable aromatic sulfinic acids are benzene sulfinic acid, toluene sulfinic acids, chlorobenzene sulfinic acids, nitrobenzene sulfinic acids and carboxybenzene sulfinic acids.

Other preferable adhesion-promoting heterocyclic compounds are thiophene, thiazole, isothiazole, thiadiazole and thiatriazole.

Suitable thiophenes are compounds of chemical formula C: 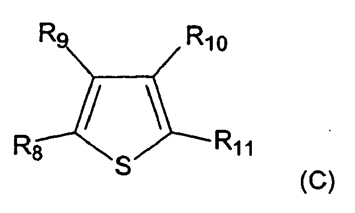 wherein R₈, R₉, R₁₀, R₁₁ are selected from the group consisting of hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl and R₁₂ -CONH- wherein R₁₂ is hydrogen, alkyl, substituted alkyl, phenyl or substituted phenyl, where R₈, R₉, R₁₀ and R₁₁ can be the same or different and can be a part of the homo- or heterocyclic ring condensed onto the thiophene ring.

Particularly preferred thiophenes are aminothiophene carboxylic acids, their esters and amides. For example, 3-aminothiophene-2-carboxylic acid methyl ester can be advantageously used.

Suitable thiazoles are compounds of chemical formula D: 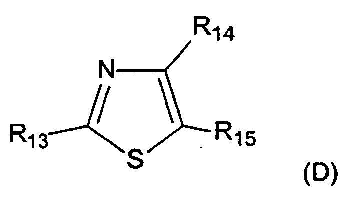 wherein R₁₃, R₁₄, R₁₅ are selected from the group consisting of hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl and R₁₆ -CONH- wherein R₁₆ is hydrogen, alkyl, substituted alkyl, phenyl or substituted phenyl, where R₁₃, R₁₄ and R₁₅ can be the same or different and can be a part of the homo- or heterocyclic ring condensed onto the thiazole ring.

Particularly suitable thiazoles are aminothiazole and substituted aminothiazole.

Other preferred thiadiazole adhesion-promoting compounds are from the group consisting of aminothiadiazoles and substituted aminothiadiazoles.

In addition, the preferred sulfonium salts are salts of trimethylsulfonium, triphenylsulfonium, methionine alkylsulfonium and methionine benzylsulfonium.

The nitrogen-containing, five-member heterocyclic compounds that do not contain any sulfur, selenium or tellurium atom in the heterocycle can be monocyclic and polycyclic condensed ring systems. For example, the compounds can contain an anellated benzene, naphthalene or pyrimidine ring provided that they are sufficiently soluble in the acid solution. It is preferable for the solution to contain triazoles, tetrazoles, imidazoles, pyrazoles and purines or their derivatives.

In particular, the solution contains triazoles of chemical formula E1: 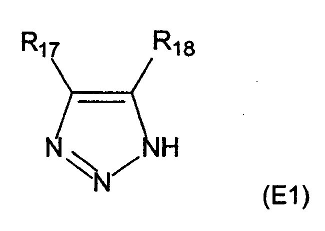 wherein R₁₇, R₁₈ are selected from the group consisting of hydrogen, alkyl, substituted alkyl, amino, phenyl, substituted phenyl and carboxyalkyl, where R₁₇ and R₁₈ can be the same or different and can be a part of the homo- or heterocyclic ring condensed onto the triazole ring.

Benzotriazole, methylbenzotriazole, ethylbenzotriazole and dimethylbenzotriazole are particularly preferable.

In addition, the solution can contain tetrazoles of chemical formula E2: 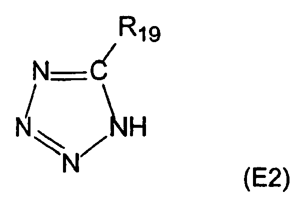 wherein R₁₉ is selected from the group consisting of hydrogen, alkyl, substituted alkyl, halogenalkyl, amino, phenyl, substituted phenyl, benzyl, carboxy, carboxyalkyl, alkoxycarbonyl, aminocarbonyl and R₂₀ -CONH wherein R₂₀ is hydrogen, alkyl, substituted alkyl, phenyl or substituted phenyl.

Preferred tetrazole compounds are 5-aminotetrazole and 5-phenyltetrazole. A preferred imidazole compound may be benzimidazole. 5-aminotetrazole, 5-phenyltetrazole, benzotriazole, methylbenzotriazole and ethylbenzotriazole are preferred compounds given their favorable solubility in the treatment solution and their availability.

Preferred combinations are benzotriazole, methylbenzotriazole, ethylbenzotriazole, 5-aminotetrazole and 5-phenyltetrazole as the nitrogen-containing, heterocyclic compounds with aminothiophene carboxylic acids, their esters and amides, aminothiazoles and substituted aminothiazoles as the heterocyclic compounds.

The process according to the invention is an extremely easy way to treat copper alloy surfaces to allow them to tightly bond with polymeric materials. Basically one step is necessary, i.e., treating the copper or copper alloy surface with the solution according to the invention to allow them to bond with polymeric materials. The adhesion does not decrease even after a long time.

The advantageous effect of the solution according to the invention was surprising since it was found that relatively small amounts of chloride and bromide of 50 mg/l and above already strongly reduce the functionality of the etching solution. Applying such solutions is disclosed in the prior art (US 5,869,130) for treating copper surfaces but is not suitable to etch copper alloy surfaces which is the subject of the present invention.

In contrast, the addition of fluoride improves the complete attack onto these alloys and leads to the desired roughness properties of the copper alloy surface: Alloys containing Si in particular, are most effectively treated, as the Si smut on the surface as well as in the solution is removed within the etching solution itself. Without the addition of fluoride, insoluble residues are formed, which lead to low adhesion values and uneven appearance, not acceptable in lead frame manufacturing. Furthermore the alloying elements often result in a decrease of the stability of the treatment solution. Dissolved iron for example catalyses the decomposition of hydrogen peroxide. Surprisingly, addition of fluoride prevents such decomposition while in contrast chloride and bromide do not reduce the decomposition rate of the treatment solution.

The properties of lead frame alloy surfaces become more and more important as a result of the lead free soldering applications for the electronic industry. Lead free soldering generates higher temperatures to the electronic components. Because of higher soldering temperatures the risk of the "popcorn effect" rises. This effect arises, when humidity penetrates the device and the water evaporates explosively upon heating during the post-treatment steps and destroys the bond between the polymeric material and the metal surface. This effect destroys electronic devices. A good adhesion of the polymeric material to the metal substrate minimizes the risk of the "popcorn effect" to occur.

As a result of the good adhesion gained by applying the solution according to the present invention, no air moisture can penetrate into the interface polymeric material/metal substrate.

The fluoride ion amount additionally affects the etch rate of the metal surface. In a certain range increase in the fluoride ion concentration results in an increased etch rate. Applying the solution according to Example 1 with a sodium fluoride concentration of 2.5 g/I results in an etch rate of 1,0 µm/min. If the solution contains 5.0 g/l sodium fluoride the etch rate is increased to 1,6 µm/min. Thereafter, further increasing the fluoride ion concentration does not affect the etch rate significantly. It has to be pointed out that the optimum amount of fluoride ions for a given metal depends on its composition and can be determined individually by standard measurement methods.

As mentioned above, the solution according to the present invention also comprises chloride ions in an amount of 5 to 40 mg per litre. It was discovered that the chloride ions have a beneficial effect on the roughness of the surface to which the solution according to the present invention is applied. Particularly good results are obtained when the concentration of chloride ions is in the range of 15 to 25 mg per litre.

In the present invention the adhesion between the alloy substrate and the polymeric material is measured quantitatively in values N/mm².

The peel strength was measured by pushing "Mold tablets" after curing and hardening, with a contact area to the test surface of 10 mm² with a Dage 4000 equipment, using a shear speed of 0,2 mm/s. The test was performed at 20°C.

In the production of lead frames, an important and widely used Si-containing alloy is C7025. Besides Cu and Ni it contains up to 1.2% of silicon.

Another alloy which is particularly preferred for use in the present invention is C194. It contains 97% of Cu, 2.3% of Fe and 0.1 % of Mn. Like the above mentioned C7025 alloy, C194 is used in the production of lead frames.

The copper alloy surfaces should first be cleaned to ensure that the treatment is effective. Any conventional cleaning solution can be used. Normally, wetting agents and sometimes complexing agents (such as triethanol-amine)-containing aqueous solutions are used.

After the cleaned copper alloy surfaces are rinsed, they can be brought into contact with a so-called predipping solution that contains one of the five-membered heterocyclic compounds dissolved in water, preferably at a concentration of 0.1-10 g/l, and especially 0.5-2 g/l. This treatment helps the adhesion-promoting layer to be formed in the subsequent treatment step. In particular, any delays in the formation of the layer are avoided. The layer starts forming directly when the surface contacts the solution of the invention.

The surfaces are then treated with the solution according to the invention without being rinsed beforehand.

The microetching by the oxidant, preferably hydrogen peroxide in connection with the acid yields microrough copper alloy surfaces. Since this increases the surface area, the subsequent adhesion of the copper alloy surfaces to the polymeric material also increases. The change in color of the surface during treatment is caused by a thin copper oxide layer. It is preferable for the acid in the solution according to the invention to be an inorganic acid, and especially sulfuric acid. Other acids can of course be used.

The treatment is preferably carried out at 20-60°C. The treatment time is preferably 10-600 sec. The higher the temperature, the faster-acting the solution. The treatment times can hence even be much shorter. From a practical standpoint, a preferable average temperature would be 35-45°C to better control the reaction. Average treatment times are 20-90 sec. In addition, a top temperature limit may have to be set due to possible incompatibilities between certain solution components at high temperatures, e.g., wetting agents that have difficulty dissolving at high temperatures.

The preferable concentration ranges in the solution are:

| | |
|---|---|
| Sulfuric acid, conc. | 10-250 g/l |
| | |
| Hydrogen peroxide, 30 weight percent | 1-100 g/l |
| | |
| Adhesion-enhancing compound: | |
| triazoles, benzotriazoles, imidazoles, tetrazoles and mixtures thereof | 0.5-50 g/l |
| | |
| purines | 0.5-50 g/l |

Further components:

| | |
|---|---|
| Sulfinic, selenic and/or telluric acid | 0.05-10 g/l |
| | |
| Adhesion-promoting heterocyclic compound | 0.05-20 g/l |
| | |
| Sulfonium, selenonium and/or telluronium salts | 0.01-10 g/l |
| | |
| fluoride ions preferred 1-10 g/l, most preferred 2-5 g/l | 0.2-25 g/l, more |
| | |
| Chloride ions | 5-40 mg/l, preferably 15-25 mg/l |

After they are treated with the solution according to the invention, the copper surfaces are rinsed. Then they are dried, e.g. with hot air.

The workpieces, for example lead frames, with the copper or copper alloy surfaces can be treated in conventional dipping systems.

The following examples serve further to clarify the invention:

### EXAMPLE 1

An aqueous solution was created by mixing the following components:

| | |
|---|---|
| Sulfuric acid, 96 weight percent | 50 ml |
| Hydrogen peroxide, | 40 ml |
| 30 weight percent in water | |
| Benzotriazole | 10 g |
| Formamidine sulfinic acid | 0.5 g |
| Sodium fluoride | 5.0 g |

| | |
|---|---|
| Sodium chloride | 33 mg |
| Deionized water added to 1 l. | |

The solution was heated to 40°C, and a copper alloy surface (lead frame C7025) containing Cu, Ni (2.2 - 4.2%), Si (0.25 - 1.2%) and small amounts of Mg and Zn was dipped in the solution for 60 sec. After being treated, the alloy was rinsed with deionized water and finally dried.
Thereafter as polymeric material a commercially available mold (KMC-289, Shinetsu) was applied to such treated alloy surface, dried and hardened at a temperature of 175°C.
The peel strengths of the lead frame was measured by a button shear test. An adhesion value of 18.5 N / mm² was found. The measured roughness, expressed in RSAI (Relative Surface Area Increase) was 44% ± 3% (absolute).

### COMPARATIVE EXAMPLE 2

Example 1 was repeated with a solution that did not contain sodium fluoride.

The lead frame surface shows black smut which can easily be taken away by finger wiping. On this sample a peel adhesion value of only 9.1 N / mm² was obtained. The measured roughness was 42% ± 3% (absolute).

### COMPARATIVE EXAMPLE 3

Example 1 was repeated with a solution that did not contain sodium chloride.

The lead frame surface shows not black smut, but the roughness was reduced to lower than 12% RSAI. The peel adhesion value was always below 5 N/mm².

### EXAMPLE 4

An aqueous solution was created by mixing the following components:

| | |
|---|---|
| Sulfuric acid, 96 weight percent | 50 ml |
| Hydrogen peroxide, 30 weight percent in water | 40 ml |
| Benzotriazole | 10 g |
| Formamidine sulfinic acid | 0.5 g |
| Sodium fluoride | 5.0 g |
| Sodium chloride | 33 mg |
| Deionized water added to 1 l. | |

The solution was heated to 40°C, and a copper alloy surface (lead frame C7025) containing Cu, Ni (2.2 - 4.2%), Si (0.25 - 1.2%) and small amounts of Mg and Zn was dipped in the solution for 60 sec. After being treated, the alloy was rinsed with deionized water and finally dried.
Thereafter, a layer of Ni-Pd-Au was deposited on the treated copper alloy surface utilizing a commercially available metallization process (Atotech Deutschland GmbH).

| | |
|---|---|
| Soak cleaner Rinsing | 50°C 3min |
| Cath. Degreaser Rinsing 5 % H2SO4 | 40°C 60sec |
| Nickel sulphamat HS Rinsing | 60°C 40sec (thickness of deposited Ni-layer ~ 0.7 ism) |
| Pallacor PPF Rinsing | 35°C 2sec (thickness of deposited Pd-layer~ 0.03 µm) |
| Aurocor PPF Rinsing, drying | 35°C 1 sec (thickness of deposited Au- layer ~ 0.005 µm) |

Finally, as polymeric material a commercially available mold (KMC-289, Shinetsu) was applied to such treated alloy surface, dried and hardened at a temperature of 150°C.
An adhesion value was achieved which is slightly smaller than that according to Example 1.

### COMPARATIVE EXAMPLE 5

Example 4 was repeated but with a solution that did not contain sodium fluoride.

The lead frame surfaces shows smut residues and had therefore to be cleaned in an additional post treatment step utilizing 50 ml/l H₂SO₄ 96%, 20 g/l sodium peroxodisulfate and 4 g/l sodium fluoride instead of 5% H₂SO₄ prior to metallization with Ni-Pd-Au. As a result only a poor peel adhesion value was obtained.

## Claims

1. A solution for treating a surface of copper alloys to improve adhesion of polymeric materials thereto, comprising
a) an oxidant which is hydrogen peroxide
b) at least one acid which is sulfuric acid
c) at least one adhesion-enhancing compound selected from the group consisting of triazoles, benzotriazoles, imidazoles, tetrazoles, purines and a compound which is a mixture of at least one nitrogen-containing, five-membered heterocyclic compound that does not contain sulfur, selenium or tellurium atoms in the heterocycle and at least one compound selected from the group consisting of sulfinic acids, selenic acids, telluric acids and heterocyclic compounds that contain at least one sulfur, selenium and/or tellurium atom in the heterocycle
**characterized in that** the solution additionally contains:
d) fluoride ions in an amount of 0.2-25 g/l,
e) chloride ions in an amount of 5 to 40 mg per litre.

2. The solution according to claim 1, **characterized in that** the triazole has the following chemical formula E1: 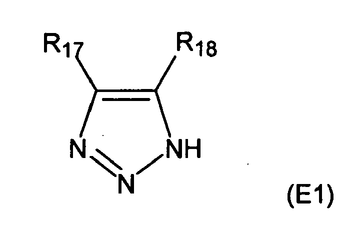 wherein R₁₇, R₁₈ are selected from the group consisting of hydrogen, alkyl, substituted alkyl, amino, phenyl, substituted phenyl and carboxyalkyl, where R₁₇ and R₁₈ can be the same or different and can be a part of the homo- or heterocyclic ring condensed onto the triazole ring.

3. The solution according to claim 1, **characterized in that** the triazole is selected from the group consisting of benzotriazole, methylbenzotriazole, ethyl benzotriazole and dimethylbenzotriazole.

4. The solution according to claim 1, **characterized in that** the tetrazole has the following chemical formula E2: 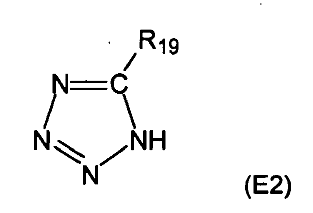 wherein R₁₉ is selected from the group consisting of hydrogen, alkyl, substituted alkyl, halogenalkyl, amino, phenyl, substituted phenyl, benzyl, carboxy, carboxyalkyl, alkoxycarbonyl, aminocarbonyl and R₂₀ -CONH wherein R₂₀ is hydrogen, alkyl, substituted alkyl, phenyl or substituted phenyl.

5. The solution according to claim 4, **characterized in that** the tetrazole is selected from the group consisting of 5-aminotetrazole and 5-phenyltetrazole.

6. The solution according to claim 1, **characterized in that** it contains sulfinic acids selected from the group consisting of aromatic sulfinic acids and compounds of chemical formula B: 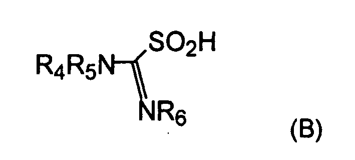 wherein R₄, R₅ and R₆ are selected from the group consisting of hydrogen, alkyl, substituted alkyl, phenyl, substituted phenyl and R₇ -(CO)- wherein R₇ is hydrogen, alkyl, substituted alkyl, phenyl or substituted phenyl, where R₄, R₅ and R₆ can be the same or different.

7. The solution according to claims 1 and 6 **characterized in that** it contains formamidine sulfinic acid.

8. The solution according to claims 1 and 7, **characterized in that** it contains aromatic sulfinic acids selected from the group consisting of benzene sulfinic acid, toluene sulfinic acids, chlorobenzene sulfinic acids, nitrobenzene sulfinic acids and carboxybenzene sulfinic acids.

9. The solution according to claims 1 and 6-8, **characterized in that** it contains at least one heterocyclic compound selected from the group consisting of thiophenes, thiazoles, isothiazoles, thiadiazoles and thiatriazoles.

10. The solution according to claim 9, **characterized in that** it contains at least one thiophene selected from the group consisting of compounds of chemical formula C: 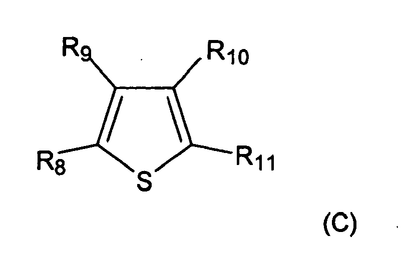 wherein R₈, R₉, R₁₀, R₁₁ are selected from the group consisting of hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl and R₁₂ -CONH- wherein R₁₂ is hydrogen, alkyl, substituted alkyl, phenyl or substituted phenyl, where R₈, R₉, R₁₀ and R₁₁ can be the same or different and can be a part of the homo- or heterocyclic ring condensed onto the thiophene ring.

11. The solution according to claims 9 and 10, **characterized in that** it contains at least one thiophene selected from the group consisting of aminothiophene carboxylic acids, their esters and amides.

12. The solution according to claims 9-11, **characterized in that** the thiazole is selected from the group consisting of compounds of chemical formula D: 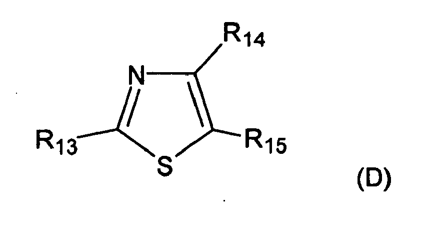 wherein R₁₃, R₁₄, R₁₅ are selected from the group consisting of hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl and R₁₆ -CONH- wherein R₁₆ is hydrogen, alkyl, substituted alkyl, phenyl or substituted phenyl, where R₁₃, R₁₄ and R₁₅ can be the same or different and can be a part of the homo- or heterocyclic ring condensed onto the thiazole ring.

13. The solution according to claims 9-12, **characterized in that** the thiazole is selected from the group consisting of aminothiazoles and substituted aminothiazoles.

14. The solution according to claims 9-13, **characterized in that** the thiadiazole is selected from the group consisting of aminothiadiazoles and substituted aminothiadiazoles.

15. The solution according to claims 1 and 6-14, **characterized in that** the nitrogen-containing, five-membered heterocyclic compound is selected from the group consisting of triazoles, tetrazoles, imidazoles, pyrazoles and purines.

16. A solution according to one of the preceding claims wherein the amount of fluoride ions is at least 0.5 g/l.

17. A solution according to one of the preceding claims **characterized in that** the fluoride ions are from a source selected from the group consisting of sodium fluoride, potassium fluoride, ammonium fluoride and tetrafluoro boric acid.

18. The solution according to one of the preceding claims **characterized in that** the amount of chloride ions is 15 to 25 mg per litre.

19. A process to pretreat copper alloy surfaces to allow a tight bond to be subsequently formed between the copper alloy surfaces and polymeric material in which the copper surfaces are brought into contact with the solution according to one of the preceding claims.

20. A process to pretreat copper alloy surfaces according to claim 19 **characterized in that** the copper alloy contains at least one alloying element selected from the group consisting of Si, Ni, Fe, Zr, P, Sn and Zn.

21. A process according to claim 20 wherein the copper alloy surface is on a lead frame and pretreated to create a tight bond between the copper alloy layers and moulding compounds.

## Patentansprüche

1. Lösung zur Behandlung einer Oberfläche von Kupferlegierungen, um die Adhäsion von Polymermaterialien daran zu verbessern, umfassend
a) ein Oxidationsmittel, welches Wasserstoffperoxid ist,
b) wenigstens eine Säure, welche Schwefelsäure ist,
c) wenigstens eine die Adhäsion verstärkende Verbindung, ausgewählt aus der Gruppe, bestehend aus Triazolen, Benzotriazolen, Imidazolen, Tetrazolen, Purinen und einer Verbindung, welche ein Gemisch aus wenigstens einer stickstoffhaltigen fünfgliedrigen heterocyclischen Verbindung, die keine Schwefel-, Selen- oder Telluratome im Heterocyclus enthält, und wenigstens einer Verbindung, ausgewählt aus der Gruppe, bestehend aus Sulfinsäuren, Selensäuren, Tellursäuren und heterocyclischen Verbindungen, die wenigstens ein Schwefel-, Selen- und/oder Telluratom im Heterocyclus enthalten, ist,
**dadurch gekennzeichnet dass** die Lösung zusätzlich enthält:
d) Fluoridionen in einer Menge von 0,2 bis 25 g/l,
e) Chloridionen in einer Menge von 5 bis 40 mg/l.

2. Lösung gemäß Anspruch 1, **dadurch gekennzeichnet, dass** das Triazol die folgende chemische Formel E1 hat: 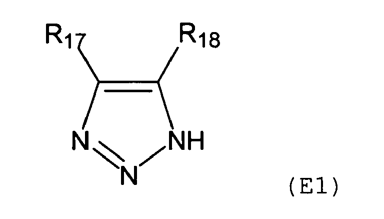 worin R₁₇, R₁₈ ausgewählt sind aus der Gruppe, bestehend aus Wasserstoff, Alkyl, substituiertem Alkyl, Amino, Phenyl, substituiertem Phenyl und Carboxyalkyl, wobei R₁₇ und R₁₈ gleich oder unterschiedlich sein können und Teil des homo- oder heterocyclischen Rings, der an den Triazolring kondensiert ist, sein können.

3. Lösung gemäß Anspruch 1, **dadurch gekennzeichnet , dass** das Triazol ausgewählt ist aus der Gruppe, bestehend aus Benzotriazol, Methylbenzotriazol, Ethylbenzotriazol und Dimethylbenzotriazol.

4. Lösung gemäß Anspruch 1, **dadurch gekennzeichnet, dass** das Tetrazol die folgende chemische Formel E2 hat: 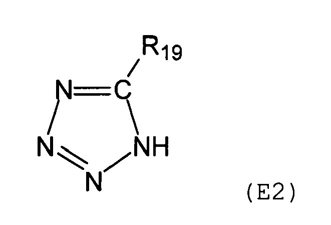 worin R₁₉ ausgewählt ist aus der Gruppe, bestehend aus Wasserstoff, Alkyl, substituiertem Alkyl, Halogenalkyl, Amino, Phenyl, substituiertem Phenyl, Benzyl, Carboxy, Carboxyalkyl, Alkoxycarbonyl, Aminocarbonyl und R₂₀-CONH, worin R₂₀ Wasserstoff, Alkyl, substituiertes Alkyl, Phenyl oder substituiertes Phenyl ist.

5. Lösung gemäß Anspruch 4, **dadurch gekennzeichnet, dass** das Tetrazol ausgewählt ist aus der Gruppe, bestehend aus 5-Aminotetrazol und 5-Phenyltetrazol.

6. Lösung gemäß Anspruch 1, **dadurch gekennzeichnet, dass** sie Sulfinsäuren enthält, die ausgewählt sind aus der Gruppe, bestehend aus aromatischen Sulfinsäuren und Verbindungen der chemischen Formel B: 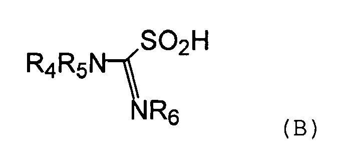 worin R₄, R₅ und R₆ ausgewählt sind aus der Gruppe, bestehend aus Wasserstoff, Alkyl, substituiertem Alkyl, Phenyl, substituiertem Phenyl und R₇-(CO)-, worin R₇ Wasserstoff, substituiertes Alkyl, Phenyl oder substituiertes Phenyl ist, wobei R₄, R₅ und R₆ gleich oder unterschiedlich sein können.

7. Lösung gemäß den Ansprüchen 1 und 6, **dadurch gekennzeichnet, dass** sie Formamidinsulfinsäure enthält.

8. Lösung gemäß den Ansprüchen 1 und 7, **dadurch gekennzeichnet, dass** sie aromatische Sulfinsäuren, ausgewählt aus der Gruppe, bestehend aus Benzolsulfinsäure, Toluolsulfinsäuren, Chlorbenzolsulfinsäuren, Nitrobenzolsulfinsäuren und Carboxybenzolsulfinsäuren, enthält.

9. Lösung gemäß den Ansprüchen 1 und 6 bis 8, **dadurch gekennzeichnet, dass** sie wenigstens eine heterocyclische Verbindung, ausgewählt aus der Gruppe, bestehend aus Thiophenen, Thiazolen, Isothiazolen, Thiadiazolen und Thiatriazolen, enhthält.

10. Lösung gemäß Anspruch 9, **dadurch gekennzeichnet, dass** sie wenigstens ein Thiophen enthält, das ausgewählt ist aus der Gruppe, bestehend aus Verbindungen der chemischen Formel C: 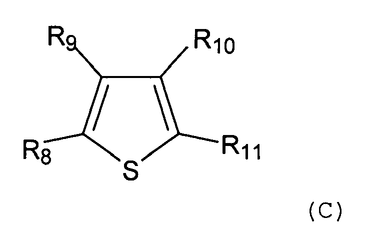 worin R₈, R₉, R₁₀, R₁₁ ausgewählt sind aus der Gruppe, bestehend aus Wasserstoff, Alkyl, substituiertem Alkyl, Phenyl, substituiertem Phenyl, Halogen, Amino, Alkylamino, Dialkylamino, Hydroxy, Alkoxy, Carboxy, Carboxyalkyl, Alkoxycarbonyl, Aminocarbonyl und R₁₂-CONH-, worin R₁₂ Wasserstoff, Alkyl, substituiertes Alkyl, Phenyl oder substituiertes Phenyl ist, wobei R₈, R₉, R₁₀ und R₁₁ gleich oder unterschiedlich sein können und Teil des homo- oder heterocyclischen Rings, der an den Thiophenring kondensiert ist, sein können.

11. Lösung gemäß den Ansprüchen 9 und 10, **dadurch gekennzeichnet, dass** wenigstens ein Thiophen, ausgewählt aus der Gruppe, bestehend aus Aminothiophencarbonsäuren, deren Estern und Amiden, enthält.

12. Lösung gemäß den Ansprüchen 9 bis 11, **dadurch gekennzeichnet, dass** das Thiazol ausgewählt ist aus der Gruppe, bestehend aus Verbindungen der chemischen Formel D: 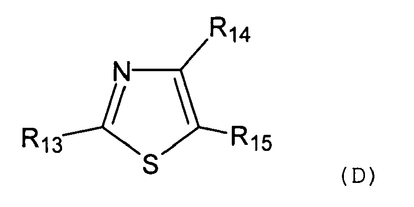 worin R₁₃, R₁₄, R₁₅ ausgewählt sind aus der Gruppe, bestehend aus Wasserstoff, Alkyl, substituiertem Alkyl, Phenyl, substituiertem Phenyl, Halogen, Amino, Alkylamino, Dialkylamino, Hydroxy, Alkoxy, Carboxy, Carboxyalkyl, Alkoxycarbonyl, Aminocarbonyl und R₁₆-CONH-, worin R₁₆ Wasserstoff, Alkyl, substituiertes Alkyl, Phenyl oder substituiertes Phenyl ist, wobei R₁₃, R₁₄ und R₁₅ gleich oder unterschiedlich sein können und Teil des homo- oder heterocyclischen Rings, der an den Thiazolring kondensiert ist, sein können.

13. Lösung gemäß den Ansprüchen 9 bis 12, **dadurch gekennzeichnet, dass** das Thiazol ausgewählt ist aus der Gruppe, bestehend aus Aminothiazolen und substituierten Aminothiazolen.

14. Lösung gemäß den Ansprüchen 9 bis 13, **dadurch gekennzeichnet, dass** das Thiadiazol ausgewählt ist aus der Gruppe, bestehend aus Aminothiadiazolen und substituierten Aminothiadiazolen.

15. Lösung gemäß den Ansprüchen 1 und 6 bis 14, **dadurch gekennzeichnet, dass** die stickstoffhaltige fünfgliedrige heterocyclische Verbindung ausgewählt ist aus der Gruppe, bestehend aus Triazolen, Tetrazolen, Imidazolen, Pyrazolen und Purinen.

16. Lösung gemäß einem der vorangehenden Ansprüche, wobei die Menge an Fluoridionen wenigstens 0,5 g/l ist.

17. Lösung gemäß einem der vorangehenden Ansprüche, **dadurch gekennzeichnet , dass** die Fluoridionen aus einer Quelle, ausgewählt aus der Gruppe, bestehend aus Natriumfluorid, Kaliumfluorid, Ammoniumfluorid und Tetrafluorborsäure, sind.

18. Lösung gemäß einem der vorangehenden Ansprüche, **dadurch gekennzeichnet , dass** die Menge an Chloridionen 15 bis 25 mg/l ist.

19. Verfahren zur Vorbehandlung von Kupferlegierungsoberflächen, um zuzulassen, dass anschließend eine dichte Bindung zwischen den Kupferlegierungsoberflächen und Polymermaterial gebildet wird, wobei die Kupferoberflächen mit der Lösung gemäß einem der vorangehenden Ansprüche in Kontakt gebracht werden.

20. Verfahren zur Vorbehandlung von Kupferlegierungsoberflächen gemäß Anspruch 19, **dadurch gekennzeichnet, dass** die Kupferlegierung wenigstens ein Legierungselement, ausgewählt aus der Gruppe, bestehend aus Si, Ni, Fe, Zr, P, Sn und Zn, enthält.

21. Verfahren gemäß Anspruch 20, wobei die Kupferlegierungsoberfläche auf einem Leiterrahmen ist und vorbehandelt wird, um eine dichte Bindung zwischen den Kupferlegierungsschichten und Gießmassen zu erzeugen.

## Revendications

1. Solution pour traiter une surface des alliages de cuivre afin d'améliorer l'adhérence du matériau polymérique lié à celle-ci comprenant:
a) un agent oxydant qui est le peroxyde d'hydrogène,
b) au moins un acide qui est l'acide sulfurique,
c) au moins un composé augmentant l'adhérence choisi parmi le groupe consistant en les triazoles, les benzotriazoles, les imidazoles, les tetrazoles, les purines et un composé qui est un mélange d'au moins un composé hétérocyclique à cinq chaînons qui contient de l'azote, mais qui ne contient pas d'atomes de soufre, de sélénium ou de tellure dans l'hétérocycle, et d'au moins un composé choisi parmi le groupe consistant en les acides sulfiniques, les acides séléniques, les acides telluriques et les composés hétérocycliques contenant au moins un atome de soufre, de sélénium ou de tellure dans l'hétérocycle,
**caractérisé en ce que** la solution contient en outre:
d) des ions fluorure en une quantité de 0,2 à 25 g/l;
e) des ions chlorure en une quantité de 5 à 40 mg/l.

2. Solution selon la revendication 1, **caractérisée en ce que** le triazole a la formule chimique E1 suivante: 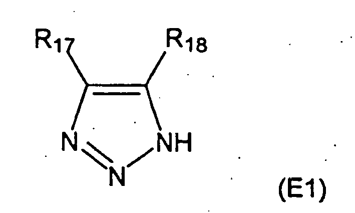 dans laquelle R₁₇, R₁₈ sont choisis parmi le groupe constitué d'hydrogène, alkyle, alkyle substitué, amino, phényle, phényle substitué et carboxyalkyle, dans laquelle R₁₇ et R₁₈ peuvent être identiques ou différents et peuvent être une part du cycle homo- ou hétérocyclique condensé au cycle triazole.

3. Solution selon la revendication 1, **caractérisée en ce que** le triazole est choisi parmi le groupe consistant en le benzotriazole, le méthylbenzotriazole, l'éthylbenzotriazole et le diméthylbenzotriazole.

4. Solution selon la revendication 1, **caractérisée en ce que** le tetrazole a la formule chimique E2 suivante: 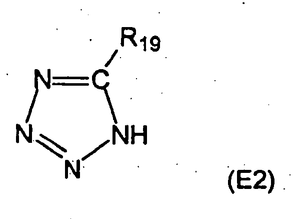 dans laquelle R₁₉ est choisi parmi le groupe constitué d'hydrogène, alkyle, alkyle substitué, halogénoalkyle, amino, phényle, phényle substitué, benzyle, carboxy, carboxyalkyle, alcoxycarbonyle, aminocarbonyle et R₂₀-CONH où R₂₀ est hydrogène, alkyle, alkyle substitué, phényle ou phényle substitué.

5. Solution selon la revendication 1, **caractérisée en ce que** le tetrazole est choisi parmi le groupe consistant en le 5-aminotetrazole et le 5-phényl tetrazole.

6. Solution selon la revendication 1, **caractérisée en ce qu'**elle contient des acides sulfinique choisis parmi le groupe consistant en les acides sulfinique aromatiques et les composés de formule chimique B: 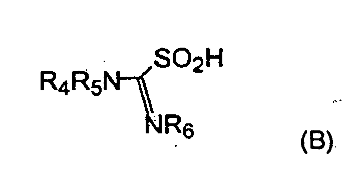 dans laquelle R₄, R₅ et R₆ sont choisis parmi le groupe constitué d'hydrogène, alkyle, alkyle substitué, phényle, phényle substitué et R₇-(CO)-, où R₇ est hydrogène, alkyle, alkyle substitué, phényle où phényle substitué, R₄, R₅ et R₆ pouvant être identiques ou différents.

7. Solution selon les revendications 1 et 6, **caractérisée en ce qu'**elle contient l'acide formamidinsulfinique.

8. Solution selon les revendications 1 et 7, **caractérisée en ce qu'**elle contient des acides sulfiniques aromatiques choisis parmi le groupe constitué d'acide benzène-sulfinique, acides toluène-sulfiniques, acides chlorobenzène-sulfiniques, acides nitrobenzène-sulfiniques et acides carboxybenzène-sulfiniques.

9. Solution selon les revendications 1 et 6-8, **caractérisée en ce qu'**elle contient au moins un composé hétérocyclique choisi parmi le groupe constitué de thiophènes, thiazoles, isothiazoles, thiadiazoles et thiatriazoles.

10. Solution selon la revendication 9, **caractérisée en ce qu'**elle contient au moins un thiophène, choisi parmi le groupe constitué de composés de la formule chimique C: 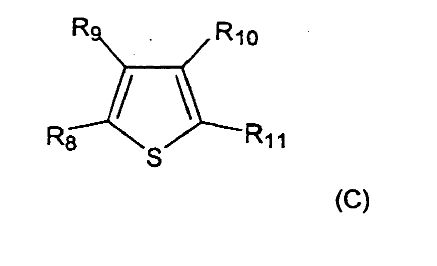 dans laquelle R₈, R₉, R₁₀, R₁₁ sont choisis parmi le groupe constitué d'hydrogène, alkyle, alkyle substitué, phényle, phényle substitué, halogène, amino, alkylamino, dialkylamino, hydroxy, alkoxy, carboxy, carboxyalkyle, alcoxycarbonyle, aminocarbonyle et R₁₂-CONH-, où R₁₂ est hydrogène, alkyle, alkyle substitué, phényle ou phényle substitué, dans laquelle R₈, R₉, R₁₀ et R₁₁ peuvent être identiques ou différents et peuvent être une part d'un cycle homo- ou hétérocyclique condensé au cycle thiophène.

11. Solution selon les revendications 9 et 10, **caractérisée en ce qu'**elle contient au moins un thiophène choisi parmi le groupe constitué d'acides aminothiophène carboxyliques, esters de ceux-ci et amides de ceux-ci.

12. Solution selon les revendications 9-11, **caractérisée en ce que** le thiazole est choisi parmi le groupe consistant en les composés de formule chimique D 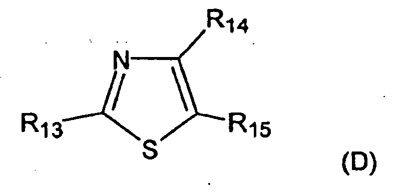 dans laquelle R₁₃, R₁₄, R₁₅ sont choisis parmi le groupe constitué d'hydrogène, alkyle, alkyle substitué, phényle, phényle substitué, halogène, amino, alkylamino, dialkylamino, hydroxyle, alcoxy, carboxy, carboxyalkyle, alcoxycarbonyle, aminocarbonyle et R₁₆-CONH-, où R₁₆ est hydrogène, alkyle, alkyle substitué, phényle ou phényle substitué, dans laquelle R₁₃, R₁₄ et R₁₅ peuvent être identiques ou différents et peuvent être une part d'un cycle homo- ou hétérocyclique condensé ou cycle thiazole.

13. Solution selon les revendications 9-12, **caractérisée en ce que** le thiazole est choisi parmi le groupe constitué d'aminothiazole et aminothiazole substitué.

14. Solution selon les revendications 9-13, **caractérisée en ce que** le thiadiazole est choisi parmi le groupe constitué d'aminothiadiazole et aminothiadiazole substitué.

15. Solution selon les revendications 1 et 6-14, **caractérisée en ce que** le composé hétérocyclique à cinq chaînons contenant de l'azote est choisi parmi le groupe constitué de triazole, tetrazole, imidazole, pyrazole, et purine.

16. Solution selon l'une quelconque des revendications précédentes, dans laquelle la quantité des ions fluorure est au moins 0,5 g/l.

17. Solution selon l'une quelconque des revendications précédentes, **caractérisée en ce que** les ions fluorure sont d'une source choisie parmi le groupe constitué de fluorure de sodium, fluorure de potassium, fluorure d'ammonium et acide fluoroborique.

18. Solution selon l'une quelconque des revendications précédentes, **caractérisée en ce que** la quantité des ions chlorure est 5 à 25 mg/l.

19. Procédé pour prétraiter des surfaces des alliages de cuivre pour permettre la formation suivante d'une liaison étanche entre les surfaces des alliages de cuivre et le matériau polymérique, dans lequel les surfaces de cuivre sont contactées avec la solution selon l'une quelconque des revendications précédentes.

20. Procédé pour prétraiter des surfaces des alliages de cuivre selon la revendication 19, **caractérisée en ce que** l'alliage de cuivre contient au moins un élément d'alliage choisi parmi le groupe constitué de Si, Ni, Fe Zr, P, Sn et Zn.

21. Procédé selon la revendication 20, dans lequel la surface de l'alliage de cuivre se trouve sur un cadre conducteur et est prétraitée pour générer une liaison étanche entre les couches d'alliage de cuivre et des substances d'inclusion.
